# FASCICULE DE BREVET EUROPEEN

(11) **EP 2 235 764 B1**
(45) Date de publication et mention de la délivrance du brevet: **03.04.2013**
(21) Numéro de dépôt: 09716051.9
(22) Date de dépôt: 12.01.2009
(51) Int. Cl.: H01L 51/52, H01L 51/56, H01L 27/32

(54) **PROCEDE DE FABRICATION D'UN DISPOSITIF D'AFFICHAGE ELECTRONIQUE RECOUVERT D'UNE PLAQUE DE PROTECTION ET SUBSTRAT POUR DISPOSITIF D'AFFICHAGE ELECTRONIQUE CORRESPONDANT**
VERFAHREN ZUM HERSTELLEN EINER DURCH EINE SCHUTZPLATTE ABGEDECKTEN ELEKTRONISCHEN ANZEIGEANORDNUNG UND TRÄGER FÜR ELEKTRONISCHE ANZEIGEANORDNUNG
METHOD FOR MAKING AN ELECTRONIC DISPLAY DEVICE COVERED BY A PROTECTION PLATE AND SUBSTRATE FOR ELECTRONIC DISPLAY DEVICE

(30) Priorité: 18.01.2008 FR 0800262
(43) Date de publication de la demande: 06.10.2010
(73) Titulaire: Commissariat à l'Énergie Atomique et aux Énergies Alternatives, 75015 Paris (FR)
(72) Inventeur: PRAT, Christophe, F-44220 Coueron (FR); MAINDRON, Tony, F-38000 Grenoble (FR)
(74) Mandataire: Bolinches, Michel Jean-Marie
(86) Numéro de dépôt international: PCT/FR2009/000034
(87) Numéro de publication internationale: WO 2009/106768

(56) Documents cités:
- JP-A- 2004 247 239
- US-A1- 2006 135 029
- US-A1- 2006 220 550
- GROZEA D ET AL: "Enhanced thermal stability in organic light-emitting diodes through nanocomposite buffer layers at the anode/organic interface" JOURNAL OF APPLIED PHYSICS, AMERICAN INSTITUTE OF PHYSICS. NEW YORK, US, vol. 101, no. 3, 9 février 2007 (2007-02-09), pages 33522-033522, XP012097594 ISSN: 0021-8979

## Description

La présente invention concerne un procédé de fabrication d'un dispositif d'affichage électronique à écran recouvert d'une plaque de protection éventuellement pourvue de filtres optiques colorés destinés à coopérer avec cet écran, ainsi qu'un substrat revêtu de cet écran pour l'obtention d'un tel dispositif. L'invention s'applique, d'une manière générale, à des écrans de type couleur ou monochrome et, en particulier, à des dispositifs d'affichage compacts à écran miniature (i.e. à microécran ou « microdisplay » en anglais).

De manière connue, les dispositifs d'affichage à microécran, comme par exemple ceux à diodes électroluminescentes organiques (« OLED » pour « organic light-emitting diode »), comprennent une zone active formée d'une matrice de pixels et une zone de connexion électrique qui est agencée de manière adjacente à cette zone active et qui comprend typiquement un alignement de contacts électriques. Ces dispositifs à microécran sont fabriqués par assemblage de filtres optiques colorés respectivement sur des points de couleur des pixels qui forment la partie active du microécran et qui recouvrent un substrat semi-conducteur typiquement constitué d'une tranche de silicium. Ces filtres sont usuellement déposés sur la face interne d'une plaque de verre que l'on vient coller sur le microécran, de manière à le protéger à la manière d'une encapsulation étanche contre l'humidité et l'oxygène de l'environnement extérieur.

En général, on réalise cet assemblage en appliquant un film de colle réticulable par rayonnement ultraviolet sur toute la surface du microécran ou de la face interne de la plaque de protection équipée des filtres, du fait qu'il est techniquement difficile de circonscrire cette application de colle à la seule zone active du microécran. Or, il résulte de ce collage de la plaque de protection sur le microécran et de la réticulation de la colle par ce rayonnement à travers la plaque ainsi assemblée la présence de colle durcie recouvrant les contacts électriques de la zone de connexion, ce qui complique l'opération ultérieure de « libération » des contacts via le découpage de la plaque au droit de la séparation entre les zones active et de connexion.

Pour résoudre ce problème de la préservation des contacts électriques du microécran ainsi recouvert de la plaque de protection, on a notamment par le passé appliqué cette colle réticulable :
- sous la forme d'un cordon entourant la zone active du microécran comme par exemple décrit dans le document US-B2-6 825 612, avec comme inconvénient en résultant une protection imparfaite du microécran par la plaque, ou
- d'une manière sélective sur cette zone active par sérigraphie, ce qui présente l'inconvénient de requérir un degré de précision élevé dans l'application des points de colle, ou encore
- en pré-structurant la face d'assemblage de la plaque de protection pour y former des cavités destinées à faire face aux contacts électriques et de profondeur très supérieure à l'épaisseur du film de colle appliqué, pour que la colle vienne se loger dans ces cavités, avec comme inconvénient l'étape préalable requise de structuration de la plaque.

Le document WO-A-2007/005228 présente un procédé d'assemblage d'une plaque de protection munie d'extensions ou pieds à coller sur un microécran, ce procédé comprenant successivement :
- une application de colle sous forme de cordons à l'interface entre ces extensions de la plaque et le microécran,
- un dépôt, sur les côtés externes de ces extensions, d'une résine photosensible de type Kapton® puis d'une couche inorganique d'étanchéité venant notamment recouvrir cette résine, puis
- une dissolution de cette résine et de la partie de couche inorganique la recouvrant pour n'obtenir finalement que la partie de cette couche localisée sur l'épaisseur des cordons de colle et nécessaire à l'étanchéité de l'assemblage.

Un inconvénient majeur du procédé décrit dans ce dernier document réside dans la difficulté de sa mise en oeuvre, qui est notamment due aux extensions de la plaque de protection et à la précision requise pour l'application de la colle et de la résine photosensible le long de ces extensions.

Le document US 2006/0220550 décrit un dispositif OLED dans lequel la zone de connexion est recouverte par une couche de protection formée d'un composé fluoré ou d'une polyoléfine.

Le document JP 2004/247239 décrit un dispositif OLED dans lequel la zone de connexion est recouverte d'une bande de kapton.

Le document US 2006/01235029 décrit un dispositif d'affichage OLED dans lequel la zone de connexion est recouverte d'une bande de protection présentant une surface hydrophobe à l'adhésif.

Un but de la présente invention est de proposer un procédé de fabrication d'un dispositif d'affichage électronique qui remédie aux inconvénients précités, ce dispositif comprenant un substrat revêtu sur l'une au moins de ses faces d'un écran, tel qu'un microécran, lequel comprend une zone active formée d'une matrice de pixels et une zone de connexion électrique, l'écran étant solidarisé via une colle réticulable par un rayonnement électromagnétique avec une plaque de protection qui est perméable à ce rayonnement et qui présente une face d'assemblage avec l'écran, ce procédé comprenant les étapes suivantes :
a) une application de la colle à l'état non réticulé sensiblement sur toute la surface de l'écran et/ou de la face d'assemblage de la plaque de protection, suite à un dépôt sur la zone de connexion d'au moins une couche organique de protection de cette zone de connexion vis-à-vis de la colle,
b) une application via cette colle de cette face d'assemblage contre l'écran,
c) une émission dudit rayonnement à travers la plaque de protection pour réticuler la colle, puis
d) un enlèvement d'une portion de la plaque de protection recouvrant la zone de connexion en vue de rendre cette dernière accessible électriquement, la couche de protection étant retirée de la zone de connexion par cet enlèvement ou bien par une étape ultérieure de traitement de surface.

A cet effet, le procédé selon l'invention est tel que ladite couche de protection est à base d'au moins un composé organique choisi dans le groupe constitué par les composés dérivés de diamines et les complexes organométalliques à hétérocycles.

On notera que cette couche organique de protection permet de protéger du solvant de la colle et de l'humidité ambiante les contacts électriques de la zone de connexion, tout en pouvant être facilement retirée pendant ou après l'opération de découpage de la plaque au droit de la séparation entre les zones active et de connexion, pour libérer ces contacts électriques.

On notera également que la protection efficace de la zone de connexion qui est procurée par cette couche organique selon l'invention rend possible une application aisée de la colle sur toute la surface de l'écran et/ou de la face interne de la plaque de protection, en comparaison de l'application sélective ou sous forme de cordons de colle utilisée dans l'art antérieur précité.

Avantageusement, ladite couche de protection présente une adhésion suffisamment réduite à la zone de connexion pour pouvoir être enlevée directement par un arrachement mécanique à l'étape d) précitée avec ladite portion de la plaque recouverte de la colle.

En variante, on peut retirer ladite couche de protection par une étape de dissolution de celle-ci postérieure à l'étape d), au moyen d'un solvant approprié à cette couche, par exemple de l'acétone, un alcool ou même de l'eau, à titre non limitatif.

Selon une autre caractéristique de l'invention, ledit ou chaque composé organique de ladite couche de protection entre dans la composition du ou de chaque écran du dispositif d'affichage.

On notera que cette utilisation d'un matériau courant et déjà employé pour la réalisation de l'écran en cours d'assemblage ne requiert pas d'étape de fabrication supplémentaire.

Avantageusement, ladite couche de protection peut présenter une épaisseur comprise entre 5 nm et 100 nm et elle est déposée par une technique d'évaporation ou par voie liquide.

De préférence, ladite couche de protection peut être constituée ou être à base :
- d'un dérivé de diamine choisi dans le groupe constitué par la N,N'-diphényl-N,N'-bis(1-naphthyl)-(1,1'-bisphényl)-4,4'-diamine (NPB), la N,N1-diphényl-N,N'-bis(3-méthyfphényl)-(1,1'-bisphényl)-4,4'-diamine (TPD), la 4,4',4"-tris(N-(1-naphtyl)-N-phényl-amino)trisphényl-amine (1T-NATA) et la 4,4',4"-tris(N-(2-naphtyl)-N-phényl-amino)-trisphényl-amine (2T-NATA) ;
- d'un complexe organométallique dérivé de quinoléine ou de benzoquinoléine, de préférence choisi dans le groupe constitué par le tris-(8-hydroxyquinoléinate) d'aluminium (III) (Alq3), le tris-(8-hydroxyquinoléinate) de gallium (III) (Gaq3), le tris-(8-hydroxyquinoléinate) d'indium (III) (Inq3), le tris(5-methyl-8-quinolinolate) d'aluminium (Almq3), le bis(10-hydroxybenzo[h]-quinoléinato) de béryllium (BeBq2) et le biphénoxy-bi(8-quinoléinolato) d'aluminium (BAlq) ; ou bien
- d'un complexe organométallique ayant un ligand à base d'oxazole ou de thiazole, de préférence le bis[2-(2-hydroxyphényl)-benzooxazolate] de zinc (Zn(BOX)2) et le bis[2-(2-hydroxyphényl)-benzothiazolate] de zinc (Zn(BTZ)2).

Encore plus préférentiellement, cette couche de protection est constituée de N,N'-diphényl-N,N'-bis(1-naphthyl)-(1,1'-bisphényl)-4,4'-diamine (NPB) ou bien de tris-(8-hydroxyquinoléinate) d'aluminium (III) (Alq3).

Par « dispositif d'affichage électronique », on entend de manière connue dans la présente description tout afficheur par exemple à cristaux liquides (« LCD » ou « liquid crystal display »), à écran à émission par effet de champ (« FED » ou « field-emission display ») ou à écran électroluminescent, à titre non limitatif. Quant à la zone active du ou de chaque écran, elle peut être indifféremment de type à matrice active ou passive.

Avantageusement, le ou chaque écran du dispositif fabriqué par le procédé selon l'invention est un microécran électroluminescent pouvant être de type organique ou inorganique, i.e. incorporant au moins un film organique (respectivement inorganique) entre deux électrodes inférieure et supérieure qui servent respectivement d'anode et de cathode pour le dispositif et dont l'une au moins est transparente à la lumière émise par ce microécran.

A titre encore plus avantageux, le ou chaque écran est un microécran de type « OLED », i.e. à diodes électroluminescentes organiques, dans lequel la couche organique de protection selon l'invention est à base d'au moins un composé organique précisément utilisé dans ce film organique.

On notera que l'énumération précitée de composés organiques utilisables dans le procédé selon l'invention a été donnée à titre non limitatif, d'autres composés pouvant être utilisés, en particulier ceux de la sous-couche de transfert de trous (« HTL » pour « hole transport layer »), de la sous-couche d'émission (« EML » pour « emitting layer »), et de la sous-couche de transfert d'électrons (« ETL » pour « electron transport layer ») de ces microécrans « OLED ».

A titre de matériaux utilisables pour réaliser ledit substrat et la plaque de protection, on peut respectivement citer tout matériau semi-conducteur, de préférence le silicium ou le silicium sur verre, et tout matériau perméable audit rayonnement et avantageusement à la lumière émise par l'écran, tel que le verre ou une matière plastique.

Concernant la plaque de protection, elle peut dans le cas particulier d'un écran couleur être pourvue de filtres optiques colorés sur sa face d'assemblage avec l'écran, de telle manière que ces filtres soient appliqués à l'étape b) précitée en regard des points de couleur correspondants de chacun des pixels de l'écran. On notera que l'écran du dispositif selon l'invention pourrait ne pas nécessiter l'adjonction de filtres optiques colorés à cette plaque de protection, laquelle permettrait alors simplement d'encapsuler l'écran.

Selon une autre caractéristique de l'invention, ladite zone de connexion du ou de chaque écran peut être formée par au moins un alignement de connecteurs situé à l'extérieur de ladite zone active et par exemple à proximité d'un bord périphérique de l'écran.

La colle utilisée dans ce procédé selon l'invention peut être toute colle réticulable par un rayonnement électromagnétique du domaine visible ou invisible, tel qu'un rayonnement ultraviolet, à titre non limitatif. Cette colle réticulable par un tel rayonnement ultraviolet peut être par exemple une colle de type acrylate ou époxy mono-composant ou bi-composants.

Un substrat pour dispositif d'affichage électronique selon l'invention, ce substrat étant revêtu sur l'une au moins de ses faces d'un écran, tel qu'un microécran à diodes électroluminescentes organiques (« OLED »), comprend une zone active formée d'une matrice de pixels et une zone de connexion électrique, l'écran étant destiné à être solidarisé sur sensiblement toute sa surface via une colle réticulable par un rayonnement électromagnétique avec une plaque de protection qui est perméable à ce rayonnement et qui présente une face d'assemblage avec l'écran, la zone de connexion étant revêtue d'au moins une couche organique de protection vis-à-vis de la colle telle que définie précédemment, cette couche étant apte à être retirée directement de cette zone de connexion par l'enlèvement d'une portion de la plaque de protection collée sur cette zone ou bien par dissolution suite à cet enlèvement, en vue de rendre cette zone accessible électriquement.

Ce substrat selon l'invention est tel que ladite couche de protection est à base d'au moins un composé organique choisi dans le groupe constitué par les composés dérivés de diamines et les complexes organométalliques à hétérocycles, ce composé organique étant de préférence utilisé dans la composition du ou de chaque écran et cette couche de protection présentant de préférence une adhésion suffisamment réduite à la zone de connexion et une épaisseur comprise entre 5 nm et 100 nm.

Comme indiqué ci-dessus, ladite couche de protection est déposée par une technique d'évaporation ou par voie liquide et ledit ou chaque composé organique est avantageusement utilisé dans la composition du ou de chaque écran.

D'autres avantages, caractéristiques et détails de l'invention ressortiront du complément de description qui va suivre en référence à des dessins annexés, donnés uniquement à titre d'exemples et dans lesquels :
la figure 1 est une vue de dessus schématique des zones active et de connexion d'un microécran d'un dispositif d'affichage selon l'invention, destiné à être recouvert d'une plaque de protection pourvue de filtres colorés,
la figure 2 est une vue schématique éclatée en coupe transversale d'un dispositif d'affichage selon l'invention montrant l'application de la colle réticulable sur la plaque, en vue d'assembler celle-ci sur le microécran de la figure 1 dont la zone de connexion a été préalablement recouverte de la couche organique de protection selon l'invention,
la figure 3 est une vue schématique en coupe transversale du dispositif d'affichage de la figure 2 montrant l'étape de réticulation de la colle après mise en contact de la plaque de protection et du microécran,
la figure 4 est une vue schématique en coupe transversale du dispositif de la figure 3 suite à cette étape de réticulation, montrant le découpage du substrat et de la plaque de protection pour obtenir la partie utile du microécran en libérant l'accès à la zone de connexion, et
la figure 5 est une vue schématique en coupe transversale du dispositif de la figure 4 une fois découpé et dont la zone de connexion du microécran a été débarrassée de la couche organique.

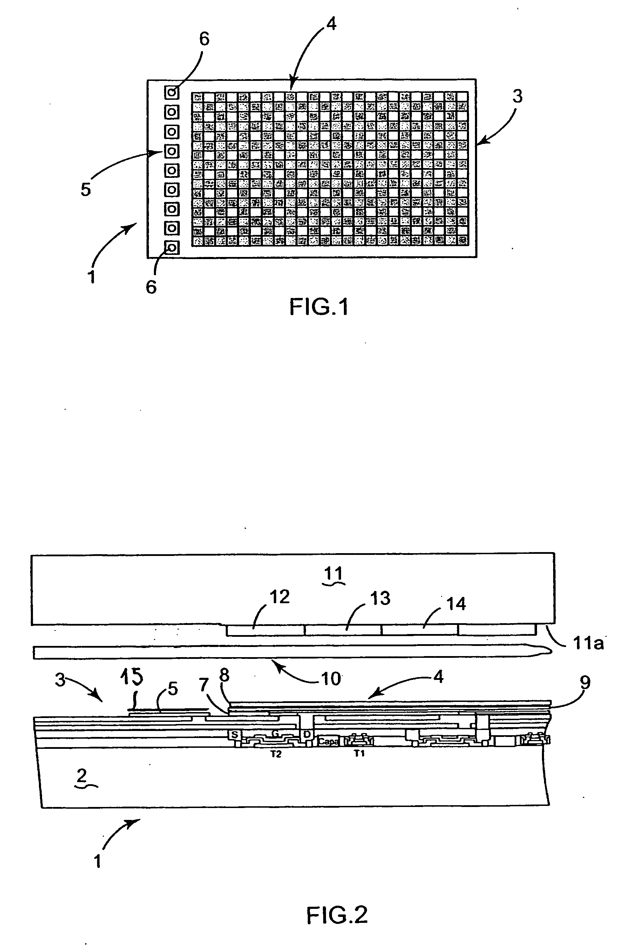

Le dispositif d'affichage électronique en couleur 1 illustré à la figure 1 est dans cet exemple de type « OLED », comprenant de manière connue un substrat 2 typiquement en silicium ou en silicium sur verre (voir figures 2 à 5) revêtu d'un microécran 3 qui comprend une zone active 4 formée d'une matrice de pixels et une zone de connexion électrique 5 extérieure à la zone active 4. La zone active 4 surmonte une structure de circuit intégré représentée de manière symbolique aux figures 2 à 5 par une source S, une grille G, un drain D, deux transistors T1 et T2 et un condensateur « capa ». La zone de connexion 5 est par exemple formée d'un alignement de contacts 6 ou connecteurs électriques pour l'établissement d'une différence de potentiel entre des électrodes 7 et 8 intégrées au microécran 3.

Dans cet exemple de microécran 3 électroluminescent « OLED » illustré aux figures 2 à 5, un film organique 9 (monocouche ou multicouches) est intercalé entre les deux électrodes inférieure 7 et supérieure 8 qui servent respectivement d'anode et de cathode pour le dispositif 1 et dont l'une au moins est transparente à la lumière émise par le microécran 3 afin de faire rayonner la lumière émise vers l'extérieur du dispositif 1. Quant au film organique d'intercalation 9, il est conçu pour transférer les électrons et les trous qui proviennent des électrodes 7 et 8 et qui sont recombinés pour générer des excitons et donc l'émission de lumière.

Comme illustré à la figure 2, antérieurement à l'étape d'assemblage via une colle 10 réticulable par un rayonnement UV d'une plaque de protection 11 sur le microécran 3, on dépose selon l'invention, sur la zone de connexion 5 de ce dernier, une couche organique de protection 15 notamment apte à protéger les contacts électriques 6 de la zone 5 vis-à-vis de cette colle 10 et de l'humidité ambiante.

De manière connue, la plaque de protection 11 est destinée à former un capot d'encapsulation typiquement en verre ou en plastique qui est perméable à ce rayonnement et également avantageusement à la lumière émise par le microécran 3 lorsque l'émission se fait à travers cette plaque 11, et qui peut être pourvue de filtres colorés 12, 13 et 14 (rouges, verts et bleus) sur sa face interne 11 a d'assemblage avec le microécran 3, de manière que les filtres 12 à 14 soient respectivement appliqués contre les points de couleur de chaque pixel de la zone active 4.

A titre de colle 10 réticulable par rayonnement UV pouvant être utilisée, on peut par exemple citer les colles DELO Katiobond 45952 (époxy monocomposant), DELO Photobond 4302 (acrylate monocomposant), Dymax 425 (acrylate monocomposant), Dymax X-516-99-E (acrylate monocomposant), Dymax 628-VLV (acrylate monocomposant), Polytec Pl OG146 (époxy monocomposant), Polytec Pl OG114-4 (époxy monocomposant), Polytec Pl 301-2, parties A et B (époxy bi-composants), Polytec Pl 301-2FL, parties A et B (époxy bi-composants), Polytec Pl OG142-13 (époxy monocomposant) et Epotecni OAD061 (époxy monocomposant).

Comme indiqué précédemment, la couche organique de protection 15 selon l'invention est conçue pour présenter une adhésion suffisamment réduite à la zone de connexion 5 pour pouvoir être enlevée directement par un arrachement mécanique ultérieur d'une portion de la plaque de protection 11 recouverte de la colle 10, et/ou pour pouvoir être aisément retirée suite à cet arrachement, par exemple par dissolution au moyen d'un solvant approprié. Cette couche de protection 15 est avantageusement à base d'un composé organique déjà utilisé pour la fabrication du microécran 3, pour la réalisation des composants électroniques par exemple ou comme matériau émissif, et elle est de préférence à base d'un composé organique pouvant être en particulier un composé dérivé d'une diamine, comme par exemple la N,N'-diphényl-N,N'-bis(1-naphthyl)-(1,1'-bisphényl)-4,4'-diamine (NPB), ou un complexe organométallique à hétérocycles, comme par exemple le tris-(8-hydroxyquinoléinate) d'aluminium (III) (Alq3).

Avantageusement, ladite couche de protection peut présenter une épaisseur comprise entre 5 nm et 100 nm et elle est déposée par une technique d'évaporation. Il est également possible de déposer la couche de protection par voie liquide, par exemple par jet d'encre.

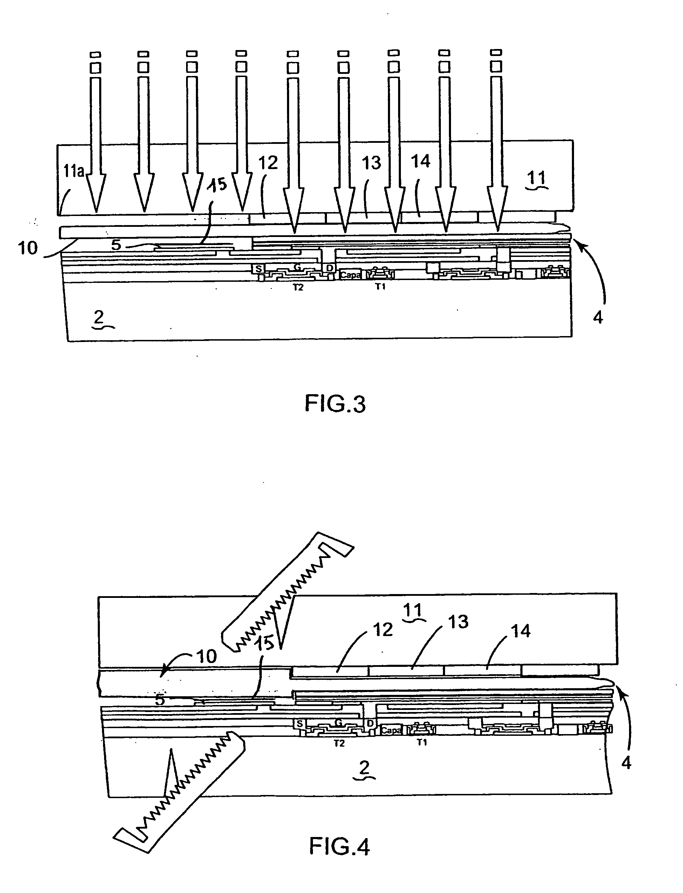

Après l'étape de réticulation de la colle 10 séparant le microécran 3 de la plaque de protection 11 qui est illustrée à la figure 3, on procède au découpage de la structure au droit du bord externe de la zone de connexion 5. On peut ensuite procéder à la découpe de la plaque de protection 11 au droit et au dessus de la ligne de séparation entre la zone active 4 et la zone de connexion 5, pour libérer cette dernière (voir figure 4).

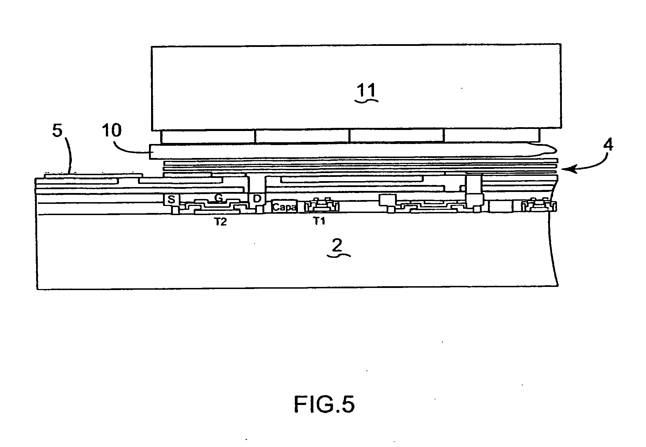

Dans le cas où la couche organique 15 a été entièrement emportée avec la colle 10 lors de l'enlèvement de la portion ainsi découpée de la plaque de protection 11, grâce à son adhésion très réduite avec la zone de connexion 5, on obtient directement le dispositif de la figure 5 où cette zone 5 est totalement libre d'accès pour réaliser les connexions électriques requises.

Dans le cas où cet enlèvement de la portion découpée de la plaque de protection 11 ne suffit pas à enlever complètement cette couche organique 15, on procède à l'élimination de la couche résiduelle, par exemple par dissolution de celle-ci en utilisant un solvant adapté, tel que de l'acétone, un alcool ou de l'eau. Cette élimination peut être également réalisée par laser ou par toute autre technique adaptée.

De cette manière, on notera que la couche organique de protection selon l'invention permet de protéger efficacement la zone de connexion 5 du microécran 3 lors de l'assemblage par collage de la plaque de protection 11 sur ce dernier, sans pénaliser l'accessibilité ultérieure de cette zone 5 après réalisation de l'assemblage.

## Revendications

1. Procédé de fabrication d'un dispositif d'affichage électronique (1) comprenant un substrat (2) revêtu sur l'une au moins de ses faces d'un écran (3), tel qu'un microécran, lequel comprend une zone active (4) formée d'une matrice de pixels et une zone de connexion électrique (5), l'écran étant solidarisé par l'intermédiaire d'une colle réticulable (10) par un rayonnement électromagnétique avec une plaque de protection (11) qui est perméable à ce rayonnement et qui présente une face d'assemblage (11a) avec l'écran, ce procédé comprenant les étapes suivantes :
a) une application de la colle à l'état non réticulé sensiblement sur toute la surface de l'écran et/ou de la face d'assemblage de la plaque de protection, suite à un dépôt sur la zone de connexion d'au moins une couche organique (15) de protection de cette zone de connexion vis-à-vis de la colle,
b) une application via cette colle de cette face d'assemblage contre l'écran,
c) une émission dudit rayonnement à travers la plaque de protection pour réticuler la colle, puis
d) un enlèvement d'une portion de la plaque de protection recouvrant la zone de connexion en vue de rendre cette dernière accessible électriquement, la couche de protection étant retirée de la zone de connexion par cet enlèvement ou bien par une étape ultérieure de traitement de surface,
**caractérisé en ce que** ladite couche de protection est à base d'au moins un composé organique choisi dans le groupe constitué par les composés dérivés de diamines et les complexes organométalliques à hétérocycles.

2. Procédé selon la revendication 1, **caractérisé en ce que** ledit ou chaque composé organique entre dans la composition du ou de chaque écran (3).

3. Procédé selon une des revendications précédentes, **caractérisé en ce que** ladite couche de protection (15) présente une épaisseur comprise entre 5 nm et 100 nm et est déposée par une technique d'évaporation ou par voie liquide.

4. Procédé selon une des revendications précédentes, **caractérisé en ce que** ladite couche de protection (15) présente une adhésion suffisamment réduite à la zone de connexion (5) pour pouvoir être enlevée directement à l'étape d) avec ladite portion de la plaque (11) recouverte de la colle (10).

5. Procédé selon la revendication 4, **caractérisé en ce que** ladite couche de protection (15) est à base d'un dérivé de diamine choisi dans le groupe constitué par la N,N'-diphényl-N,N'-bis(1-naphthyl)-(1,1'-bisphényl)-4,4'-diamine (NPB), la N,N1-diphényl-N,N'-bis(3-méthylphényl)-(1,1'-bisphényl)-4,4'-diamine (TPD), la 4,4',4"-tris(N-(1-naphtyl)-N-phényl-amino)trisphényl-amine (1T-NATA) et la 4,4',4"-tris(N-(2-naphtyl)-N-phényl-amino)-trisphényl-amine (2T-NATA).

6. Procédé selon la revendication 4, **caractérisé en ce que** ladite couche de protection (15) est à base d'un complexe organométallique dérivé de quinoléine ou de benzoquinoléine, de préférence choisi dans le groupe constitué par le tris-(8-hydroxyquinoléinate) d'aluminium (III) (Alq3), le tris-(8-hydroxyquinoléinate) de gallium (III) (Gaq3), le tris-(8-hydroxyquinoléinate) d'indium (III) (Inq3), le tris(5-methyl-8-quinolinolate) d'aluminium (Almq3), le bis(10-hydroxybenzo[h]-quinoléinato) de béryllium (BeBq2) et le biphénoxy-bi(8-quinoléinolato) d'aluminium (BAlq).

7. Procédé selon la revendication 4, **caractérisé en ce que** ladite couche de protection (15) est à base d'un complexe organométallique ayant un ligand à base d'oxazole ou de thiazole, de préférence le bis[2-(2-hydroxyphényl)-benzooxazolate] de zinc (Zn(BOX)2) et le bis[2-(2-hydroxyphényl)-benzothiazolate] de zinc (Zn(BTZ)2).

8. Procédé selon une des revendications 1 à 7, **caractérisé en ce que** l'on retire ladite couche de protection (15) par un arrachement mécanique mis en oeuvre à l'étape d), cette couche de protection présentant une adhésion suffisamment réduite à la zone de connexion (5) pour pouvoir être enlevée directement avec ladite portion de la plaque (11) recouverte de la colle (10).

9. Procédé selon une des revendications 1 à 7, **caractérisé en ce que** l'on retire ladite couche de protection (15) par une étape de dissolution de celle-ci postérieure à l'étape d), au moyen d'un solvant approprié à cette couche.

10. Procédé selon une des revendications précédentes, **caractérisé en ce que** la colle (10) est réticulable par un rayonnement ultraviolet, étant de préférence une colle de type acrylate ou époxy.

11. Procédé selon une des revendications précédentes, **caractérisé en ce que** la zone de connexion (5) est formée par au moins un alignement de connecteurs (6) situé à proximité d'un bord périphérique de l'écran (3), ledit substrat (2) étant semi-conducteur et de préférence en silicium ou en silicium sur verre.

12. Procédé selon une des revendications précédentes, **caractérisé en ce que** la plaque de protection (11) est pourvue de filtres optiques colorés (12, 13, 14) sur sa face d'assemblage (11a) avec l'écran (3), de telle manière que ces filtres soient appliqués à l'étape b) en regard des points de couleur correspondants de chacun desdits pixels, cette plaque de protection (11) étant perméable à la lumière émise par l'écran et étant par exemple réalisée en verre ou en matière plastique.

13. Procédé selon une des revendications précédentes, **caractérisé en ce que** le ou chaque écran (3) est un microécran électroluminescent, de préférence de type organique, incorporant au moins un film organique (9) entre deux électrodes inférieure (7) et supérieure (8) qui servent respectivement d'anode et de cathode pour le dispositif (1) et dont l'une au moins est transparente à la lumière émise par ce microécran.

14. Procédé selon la revendication 13, **caractérisé en ce que** le ou chaque écran (3) est un microécran à diodes électroluminescentes organiques (« OLED »), dans lequel ladite couche de protection (15) est à base d'au moins un composé organique utilisé dans ledit film organique (9).

15. Substrat (2) pour dispositif d'affichage électronique (1), ce substrat étant revêtu sur l'une au moins de ses faces d'un écran (3), tel qu'un microécran à diodes électroluminescentes organiques (« OLED »), qui comprend une zone active (4) formée d'une matrice de pixels et une zone de connexion électrique (5), l'écran étant destiné à être solidarisé sur sensiblement toute sa surface par l'intermédiaire d'une colle réticulable (10) par un rayonnement électromagnétique avec une plaque de protection (11) qui est perméable à ce rayonnement et qui présente une face d'assemblage (11a) avec l'écran, la zone de connexion étant revêtue d'au moins une couche organique (15) de protection vis-à-vis de la colle, cette couche étant apte à être retirée directement de cette zone de connexion par l'enlèvement d'une portion de la plaque de protection collée sur cette zone ou bien par dissolution suite à cet enlèvement, en vue de rendre cette zone accessible électriquement, **caractérisé en ce que** ladite couche de protection est à base d'au moins un composé organique choisi dans le groupe constitué par les composés dérivés de diamines et les complexes organométalliques à hétérocycles, ce composé organique étant de préférence utilisé dans la composition du ou de chaque écran et cette couche de protection présentant de préférence une adhésion suffisamment réduite à la zone de connexion et une épaisseur comprise entre 5 nm et 100 nm.

## Claims

1. A method for fabricating an electronic display device (1) comprising a substrate (2) coated on at least one of its sides with a display (3), such as a microdisplay, which comprises an active zone (4) formed from a matrix of pixels and an electrical connection zone (5), the display being fastened by means of an adhesive (10) which is crosslinkable by electromagnetic radiation, with a protective sheet (11) which is permeable to this radiation and has a face (11a) for assembly with the display, this method comprising the following steps:
a) the adhesive is applied in the uncrosslinked state substantially over the entire surface of the display and/or of the assembly face of the protective sheet, after deposition on the connection zone of at least one organic layer (15) for protecting this connection zone from the adhesive;
b) this assembly face is applied against the display via this adhesive;
c) said radiation is emitted through the protective sheet in order to crosslink the adhesive; and then
d) a portion of the protective sheet covering the connection zone is removed for the purpose of making said zone electrically accessible, the protective layer being pulled off the connection zone by this removal or else removed by a subsequent surface treatment step,
**characterized in that** said protective layer is based on at least one organic compound chosen from the group consisting of diamine-derived compounds and heterocyclic organometallic complexes.

2. The method as claimed in claim 1, **characterized in that** said or each organic compound forms part of the composition of the or each display (3).

3. The method as claimed in either of the preceding claims, **characterized in that** said protective layer (15) has a thickness of between 5 nm and 100 nm and is deposited by an evaporation technique or a liquid technique.

4. The method as claimed in one of the preceding claims, **characterized in that** said protective layer (15) has a sufficiently low adhesion to the connection zone (5) so as to be able to be removed directly in step d) together with said portion of the sheet (11) covered with the adhesive (10).

5. The method as claimed in claim 4, **characterized in that** said protective layer (15) is based on a diamine derivative chosen from the group consisting of N,N'-diphenyl-N,N'-bis(1-naphthyl)-(1,1'-bisphenyl)-4,4'-diamine (NPB), N,N1-diphenyl-N,N'-bis(3-methylphenyl)-(1,1'-bisphenyl)-4,4'-diamine (TPD), 4,4'4"-tris(N-(1-naphthyl)-N-phenylamino) trisphenylamine (1T-NATA) and 4,4',4"-tris (N-(2-naphthyl)-N-phenylamino) trisphenylamine (2T-NATA).

6. The method as claimed in claim 4, **characterized in that** said protective layer (15) is based on an organometallic complex derived from quinoline or benzoquinoline, preferably chosen from the group consisting of tris(8-hydroxyquinolinato)aluminum(III) (Alq3), tris(8-hydroxyquinolinato)gallium(III) (Gaq3), tris(8-hydroxyquinolinato)indium(III) (Inq3), tris(5-methyl-8-quinolinolato)aluminum (Almq3), bis(10-hydroxybenzo[h]quinolinato)beryllium (BeBq2) and biphenoxy-bi(8-quinolinolato)aluminum (BAlq).

7. The method as claimed in claim 4, **characterized in that** said protective layer (15) is based on an organometallic complex having an oxazole-based or thiazole-based ligand, preferably bis[2-(2-hydroxyphenyl)benzoxazolato]zinc (Zn(BOX)2) and bis[2-(2-hydroxyphenyl)benzothiazolato)zinc (Zn(BTZ)2).

8. The method as claimed in one of claims 1 to 7, **characterized in that** said protective layer (15) is removed by a mechanical tearing operation carried out in step d), this protective layer adhering sufficiently weakly to the connection zone (5) so as to be able to be removed directly with said portion of the sheet (11) covered with the adhesive (10).

9. The method as claimed in one of claims 1 to 7, **characterized in that** said protective layer (15) is removed, after step d), in a step of dissolving it by means of a solvent appropriate to this layer.

10. The method as claimed in one of the preceding claims, **characterized in that** the adhesive (10) is crosslinkable by ultraviolet radiation, preferably being an adhesive of the acrylate or epoxy type.

11. The method as claimed in one of the preceding claims, **characterized in that** the connection zone (5) is formed by at least one alignment of connectors (6) which is located close to a peripheral edge of the display (3), said substrate (2) being a semiconductor and preferably silicon or silicon on glass.

12. The method as claimed in one of the preceding claims, **characterized in that** the protective sheet (11) is provided with optical color filters (12, 13, 14) on its face (11a) for assembly with the display (3), in such a way that these filters are applied in step b) facing the corresponding color dots of each of said pixels, said protective sheet (11) being permeable to the light emitted by the display and being for example made of glass or made of plastic.

13. The method as claimed in one of the preceding claims, **characterized in that** the or each display (3) is an electroluminescent microdisplay, preferably of the organic type, incorporating at least one organic film (9) between two electrodes, namely the lower electrode (7) and the upper electrode (8), which serve respectively as anode and cathode for the device (1), at least one of said electrodes being transparent to the light emitted by this microdisplay.

14. The method as claimed in claim 13, **characterized in that** the or each display (3) is an OLED (organic light-emitting diode) microdisplay in which said protective layer (15) is based on at least one organic compound used in said organic film (9).

15. A substrate (2) for an electronic display device (1), this substrate being coated on at least one of its sides with a display (3), such as an OLED (organic light-emitting diode) microdisplay, which comprises an active zone (4) formed from a matrix of pixels and an electrical connection zone (5), the display being intended to be fastened over substantially its entire surface via an adhesive (10) which is crosslinkable by electromagnetic radiation, to a protective sheet (11) which is permeable to this radiation and has an assembly face (11a) for assembly to the display, the connection zone being coated with at least one organic layer (15) for protecting it from the adhesive, this layer being able to be removed directly from this connection zone by removing a portion of the protective sheet bonded to this zone or else by dissolution following this removal, in order to make this zone electrically accessible, **characterized in that** said protective layer is based on at least one organic compound chosen from the group consisting of diamine-derived compounds and heterocyclic organometallic complexes, this organic compound preferably being used in the composition of the or each display and this protective layer preferably having a sufficiently low adhesion to the connection zone and a thickness of between 5 nm and 100 nm.

## Patentansprüche

1. Verfahren zur Herstellung einer elektronischen Anzeigevorrichtung (1), umfassend ein Substrat (2), das an wenigstens einer seiner Seiten von einem Bildschirm (3), z.B. einem Mikrobildschirm, bedeckt ist, welcher eine aktive Zone (4), die aus einer Pixelmatrix gebildet ist, und eine Zone zur elektrischen Verbindung (5) umfasst, wobei der Bildschirm mit Hilfe eines Klebstoffs (10), der durch elektromagnetische Strahlung vernetzbar ist, mit einer Abdeckplatte (11) verbunden ist, welche für diese Strahlung durchlässig ist und welche eine Seite (11a) zur Montage mit dem Bildschirm aufweist, wobei das Verfahren die folgenden Stufen umfasst:
a) Auftragung des Klebstoffs im nicht-vernetzten Zustand etwa auf die gesamte Oberfläche des Bildschirms und/oder der Seite zur Montage der Abdeckplatte (11) im Anschluss an eine Abscheidung auf der Zone zur elektrischen Verbindung wenigstens einer organischen Schutzschicht (15) für diese Zone zur Verbindung zum Schutz vor dem Klebstoff,
b) Anbringung der Seite zur Montage mit Hilfe dieses Klebstoffs an den Bildschirm,
c) Emission der Strahlung durch die Schutzabdeckung, um den Klebstoff zu vernetzen, danach
d) Abtragung eines Teils der Abdeckplatte, die die Zone zur Verbindung bedeckt, mit dem Ziel, diese letzte elektrisch zugänglich zu machen, wobei die Schutzschicht von der Zone zur Verbindung durch diese Abtragung oder auch durch eine spätere Stufe der Oberflächenbehandlung abgelöst wird,
**dadurch gekennzeichnet, dass** die Schutzschicht auf der Basis wenigstens einer organischen Verbindung ist, welche aus der Gruppe, bestehend aus Verbindungen, die von Diaminen abgeleitet sind, und metallorganischen Komplexen von Heterocyclen, ausgewählt ist.

2. Verfahren gemäß Anspruch 1, **dadurch gekennzeichnet, dass** die oder jede organische Verbindung in der Zusammensetzung des oder jedes Bildschirms (3) ist.

3. Verfahren gemäß einem der vorangehenden Ansprüche, **dadurch gekennzeichnet, dass** die Schutzschicht (15) eine Dicke zwischen 5nm und 100nm aufweist und durch eine Verdampfungstechnik oder mittels Flüssigkeit abgeschieden wird.

4. Verfahren gemäß einem der vorangehenden Ansprüche, **dadurch gekennzeichnet, dass** die Schutzschicht (15) an der Zone zur Verbindung (5) eine genügend verringerte Adhäsion aufweist, um in der Stufe (d) direkt mit dem Teil der Platte (11), der vom Klebstoff (10) bedeckt ist, abgelöst zu werden.

5. Verfahren gemäß Anspruch 4, **dadurch gekennzeichnet, dass** die Schutzschicht (15) auf der Basis eines Diamin-Derivates ist, das ausgewählt ist aus der Gruppe, bestehend aus N,N'-Diphenyl-N,N'-bis(1-naphtyl)-(1,1'-bisphenyl)-4,4'-diamin (NPB), N,N1-Diphenyl-N,N'-bis(3-methylphenyl)-1,1'-bisphenyl)-4,4'-diamin (TPD), 4,4',4-Tris(N-(1-naphtyl)-N-phenyl-amino)trisphenylamin (1T-NATA) und 4,4',4"-Tris(N-(2-naphtyl)-N-phenylamino)-trisphenylamin (2T-NATA).

6. Verfahren gemäß Anspruch 4, **dadurch gekennzeichnet, dass** die Schutzschicht (15) auf der Basis eines metallorganischen Komplexes ist, der von Chinolin oder Benzochinolin abgeleitet ist, vorzugsweise aus der Gruppe bestehend aus Aluminium(III)-tris-(8-hydroxychinolinat) (Alq3), Gallium(III)-tris-(8-hydroxychinolinat) (Gaq3), Indium(III)-tris-(8-hydroxychinolinat) (Inq3), Aluminium-tris-(5-methyl-8-chinolinolat) (Almq3), Beryllium-bis(10-hydroxybenzo[h]-chinolinat) (BeBq2) und Aluminium-biphenoxy-bi(8-chinolinolat) (BAlq), ausgewählt wird.

7. Verfahren gemäß Anspruch 4, **dadurch gekennzeichnet, dass** die Schutzschicht (15) auf der Basis eines metallorganischen Komplexes ist, der einen Liganden auf Oxazol- oder Thiazol-Basis hat, vorzugsweise Zink-bis[2-(2-hydroxyphenyl)-benzoxazolat] (Zn(BOX)2) und Zink-bis[2-(2-hydroxyphenyl)-benzothiazolat] (Zn(BTZ)2) ist.

8. Verfahren gemäß einem der Ansprüche 1 bis 7, **dadurch gekennzeichnet, dass** man die Schutzschicht (15) durch eine mechanische Trennung ablöst, welche in Stufe d) durchgeführt wird, wobei diese Schutzschicht in der Zone zur Verbindung (5) eine ausreichend reduzierte Adhäsion aufweist, um direkt mit dem Teil der Platte (11), die von Klebstoff (10) bedeckt ist, abgezogen zu werden.

9. Verfahren gemäß einem der Ansprüche 1 bis 7, **dadurch gekennzeichnet, dass** man die Schutzschicht (15) durch eine Stufe der Auflösung dieser nach Stufe d) mittels eines für diese Schicht geeigneten Lösungsmittels ablöst.

10. Verfahren gemäß einem der vorangehenden Ansprüche, **dadurch gekennzeichnet, dass** der Klebstoff (10) durch ultraviolette Strahlung vernetzbar ist, wobei er vorzugsweise ein Klebstoff des Acrylat- oder Epoxy-Typs ist.

11. Verfahren gemäß einem der vorangehenden Ansprüche, **dadurch gekennzeichnet, dass** die Zone zur Verbindung (5) durch wenigstens eine Reihe von Steckverbindungen (6) gebildet wird, die sich in der Nähe des peripheren Randes des Bildschirms (3) befindet, wobei das Substrat (2) halbleitend und vorzugsweise aus Silicium oder Silicium auf Glas ist.

12. Verfahren gemäß einem der vorangehenden Ansprüche, **dadurch gekennzeichnet, dass** die Abdeckplatte (11) mit gefärbten optischen Filtern (12, 13, 14) an ihrer Seite zur Montage (11a) mit dem Bildschirm (3) derart ausgestattet ist, dass diese Filter in Stufe b) im Hinblick auf die Farbpunkte, die jedem der Pixel entsprechen, aufgetragen werden, wobei diese Abdeckplatte (11) für das Licht durchlässig ist, das von dem Bildschirm emittiert wird, und zum Beispiel aus Glas oder Kunststoffmaterial hergestellt ist.

13. Verfahren gemäß einem der vorangehenden Ansprüche, **dadurch gekennzeichnet, dass** der oder jeder Bildschirm (3) ein elektrolumineszenter Mikrobildschirm, vorzugsweise des organischen Typs, ist, der wenigstens einen organischen Film (9) zwischen zwei untere (7) und obere (8) Elektroden eingebaut hat, welche als Anode und Kathode für die Vorrichtung (1) dienen und von denen wenigstens eine für das durch diesen Mikrobildschirm emittierte Licht transparent ist.

14. Verfahren gemäß Anspruch 13, **dadurch gekennzeichnet, dass** der oder jeder Bildschirm (3) ein Mikrobildschirm mit organischen elektrolumineszenten Dioden ("OLED") ist, indem die Schutzschicht (15) auf der Basis wenigstens einer organischen Verbindung ist, die in dem organischen Film (9) verwendet wird.

15. Substrat (2) für eine elektronische Anzeigevorrichtung (1), wobei das Substrat auf wenigstens einer seiner Seiten von einem Bildschirm (3), zum Beispiel einem Mikrobildschirm mit organischen Elektroluminescenten Dioden ("OLED") bedeckt ist, der eine aktive Zone (4), gebildet aus einer Pixelmatrix, und eine Zone zur elektrischen Verbindung (5) umfasst, wobei der Bildschirm dazu bestimmt ist, auf etwa seiner gesamten Oberfläche mit Hilfe eines Klebstoffs (10), der durch elektromagnetische Strahlung härtbar ist, mit einer Abdeckplatte (11) verbunden zu werden, die für diese Strahlung durchlässig ist und die eine Seite zur Montage (11a) mit dem Bildschirm aufweist, wobei die Zone zur Verbindung mit wenigstes einer organischen Schutzschicht (15) gegenüber dem Klebstoff bedeckt ist, wobei diese Schicht geeignet ist, direkt von dieser Zone zur Verbindung durch Abtragung eines Teils der Schutzschicht, die auf diese Zone geklebt ist, oder durch Auflösung nach dieser Abtragung abgezogen zu werden, und zwar mit dem Ziel, diese Zone elektrisch zugänglich zu machen, **dadurch gekennzeichnet, dass** die Schutzschicht auf der Basis wenigstens einer organischen Verbindung ist, die aus der Gruppe, bestehend aus Verbindungen, die von Diaminen abgeleitet sind, und metallorganischen Komplexen von Heterocyclen, ausgewählt ist, wobei diese organische Verbindung vorzugsweise in der Zusammensetzung des oder jedes Bildschirms verwendet wird und diese Schutzschicht vorzugsweise eine Adhäsion aufweist, die in der Zone zur Verbindung genügend verringert ist, und eine Dicke zwischen 5nm und 100nm aufweist.
